# EUROPEAN PATENT APPLICATION

(11) **EP 2 326 001 A2**
(43) Date of publication of application: **25.05.2011**
(21) Application number: 09014461.9
(22) Date of filing: 19.11.2009
(51) Int. Cl.: H03G 3/34

(54) **Signal output device and signal output method**

(30) Priority: 19.11.2009 US 621514
(71) Applicant: MediaTek Inc., Hsin-Chu (TW)
(72) Inventor: Kao, Tsung-Kai, Jhubei City Hsinchu County (TW); Chiu, Pao-Cheng, Sindian City Taipai County (TW); Chen, Chien-Ming, Hsin-Chu City (TW)
(74) Representative: Hager, Thomas Johannes

(57) **Abstract**

A signal output device (100, 400) includes: a control circuit (102, 402) for receiving at least a first input control signal and outputting an output control signal according to at least the first input control signal, wherein the first input control signal comprises a first signal segment followed by a second signal segment; and a driver circuit (104, 404), operated according to a supply power, for receiving the output control signal from the control circuit (102, 402) and selectively generating an output signal according to the output control signal; wherein the supply power is turned on before the second signal segment of the first input control signal is received by the control circuit (102, 402); when the supply power is turned on, the driver circuit (104, 404) operates under a specific power state; and when the second signal segment of the first input control signal is received by the control circuit (102, 402), the driver circuit (104, 404) keeps operating under the specific power state.

## Description

The present invention relates to a signal output circuit and a signal output method according to pre-characterizing clauses of claims 1 and 8.

In an audio signal output system, an output circuit, which is coupled to a speaker, is utilized for generating an audio signal to the speaker according to an input signal, and the speaker is utilized for amplifying the audio signal. Conventionally, the input signal is a relatively low voltage signal and the audio signal is a relatively high voltage signal, thus the input circuit generating the input signal is operated under a low supply voltage and the output circuit is operated under a high supply voltage. For example, the high supply voltage is about 3.3V and the low supply voltage is about 1.2V. Normally, in the audio signal output system, the input circuit (low voltage device) is set after the output circuit (high voltage device) when the audio signal output system is turned on. In other words, when the audio signal output system is turned on, the function of the output circuit (high voltage device) is ready first, and the function of the input circuit (low voltage device) is ready later. Therefore, when the input circuit is ready, the input circuit will output an initial signal to the output circuit to change the state of the output circuit. For example, the initial signal may switch the output circuit to enter a discharging state from a charging state. When the state of the output circuit is changed, a sharp transition of voltage (or current) can be induced easily at the output terminal of the output circuit. Since the output circuit is coupled to the speaker, the sharp transition of voltage will induce a 'pop' noise in the speaker. Therefore, eliminating the pop noise generated by the output circuit when it is powered on is a significant concern in the audio signal output system.

This in mind, the present invention aims at providing a signal output device and a signal output method to reduce the pop noise of the output circuit.

This is achieved by a signal output device and a signal output method according to claims 1 and 8, respectively. The dependent claims pertain to corresponding further developments and improvements.

As will be seen more clearly from the detailed description following below, the claimed signal output device comprises a control circuit and a driver circuit. The control circuit receives at least a first input control signal and outputs an output control signal according to at least the first input control signal, wherein the first input control signal comprises a first signal segment followed by a second signal segment. The driver circuit is coupled to the control circuit and operated according to a supply power for receiving the output control signal from the control circuit and selectively generating an output signal according to the output control signal when the supply power is turned on; wherein the supply power is turned on before the second signal segment of the first input control signal is received by the control circuit; when the supply power is turned on, the driver circuit operates under a specific power state; and when the second signal segment of the first input control signal is received by the control circuit, the driver circuit keeps operating under the specific power state.

In addition, the claimed signal output method comprises the steps of: receiving at least a first input control signal and outputting an output control signal according to at least the first input control signal, wherein the first input control signal comprises a first signal segment followed by a second signal segment; and utilizing a control circuit, operated according to a supply power, to receive the output control signal and selectively generate an output signal according to the output control signal when the supply power is turned on; wherein the supply power is turned on before the second signal segment of the first input control signal is received; when the supply power is turned on, the control circuit operates under a specific power state; and when the second signal segment of the first input control signal is received, the control circuit keeps operating under the specific power state.

In the following, the invention is further illustrated by way of example, taking reference to the accompanying drawings. Thereof
- FIG. 1: is a diagram illustrating a signal output device according to an embodiment of the present invention,
- FIG. 2: is a timing diagram illustrating a power-on sequence of reference voltages, a first input control signal, an output control signal, and an output signal of the signal output device shown in FIG. 1,
- FIG. 3: is a timing diagram illustrating the power-on sequence of the reference voltages, the first input control signal, the output control signal, and the output signal according to a second embodiment of the signal output device shown in FIG. 1,
- FIG. 4: is a diagram illustrating the signal output device according to a third embodiment of the present invention,
- FIG. 5: is a timing diagram illustrating the power-on sequence of the reference voltages, the first input control signal, the second input control signal, the output control signal, and the output signal of the signal output device shown in FIG. 4,
- FIG. 6: is a flowchart illustrating a signal output method according to a fourth embodiment of the present invention,
- FIG. 7: is a flowchart illustrating the signal output method according to a fifth embodiment of the present invention, and
- FIG. 8: is a diagram illustrating an audio signal amplifying system according to a sixth embodiment of the present invention.

Certain terms are used throughout the description and following claims to refer to particular components. As one skilled in the art will appreciate, electronic equipment manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

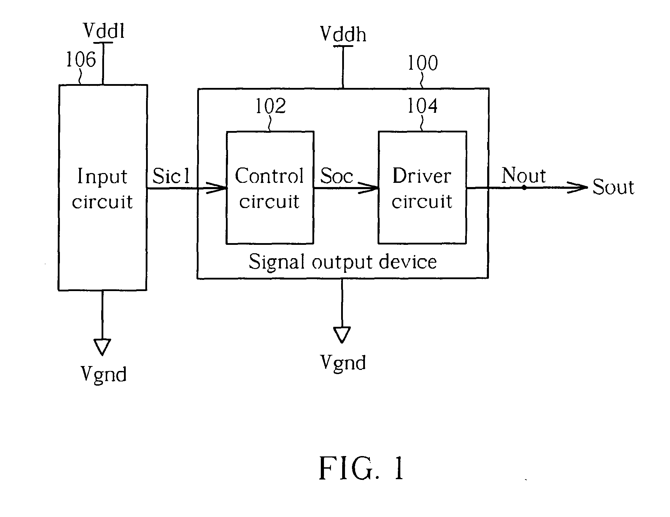

Please refer to FIG. 1. FIG. 1 is a diagram illustrating a signal output device 100 according to an embodiment of the present invention. The signal output device 100 is applicable in an audio signal output system. The signal output device 100 comprises a control circuit 102 and a driver circuit 104. The control circuit 102 receives at least a first input control signal Sic1 and outputs an output control signal Soc according to at least the first input control signal Sic1, wherein the first input control signal Sic1 comprises a first signal segment Sic11 followed by a second signal segment Sic12. The driver circuit 104 is coupled to the control circuit 102 and operated according to a first supply power for receiving the output control signal Soc from the control circuit 102 and selectively generating an output signal Sout according to the output control signal Soc when the first supply power is turned on, wherein the first supply power is defined between a relatively high reference voltage Vddh and a ground voltage Vgnd. Furthermore, the driver circuit 104 is coupled to a speaker (not shown), and the speaker is utilized for amplifying the output signal Sout. In other words, the driver circuit 104 is an audio signal output circuit in this embodiment, and the output signal Sout is an audio signal.

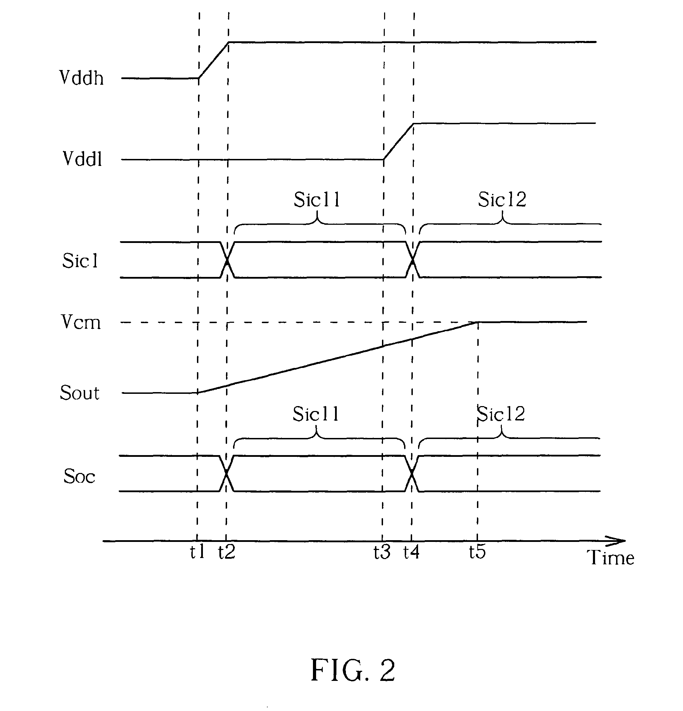

Please note that, to clearly illustrate the operation of the signal output device 100, an input circuit 106 is further included in FIG. 1. In this embodiment, the input circuit 106 is implemented by a register, but this is not a limitation of the present invention. The register may be controlled by firmware or a hardware controller, and the register may load/store a specific data from the hardware controller and output the specific data as the first input control signal Sic1 to the signal output device 100 when power up. Moreover, the register may store a default data and output the default data as the first input control signal Sic1 to the signal output device 100 when power up. The input circuit 106 operated under a second supply power is utilized for generating the first input control signal Sic1, wherein the second supply power is defined between a relatively low reference voltage Vddl and the ground voltage Vgnd, and the reference voltage Vddh is higher than the reference voltage Vddl. More specifically, in one embodiment of the present invention, the signal output device 100 is an analog circuit, and the input circuit 106 is a digital circuit, thus the reference voltage Vddh is in analog domain and the reference voltage Vddl is in digital domain. Furthermore, when the audio signal output system is powered-on, the reference voltage Vddh is turned on (or settled) faster than the reference voltage Vddl as shown in FIG. 2. FIG. 2 is a timing diagram illustrating a power-on sequence of the reference voltage Vddh, the reference voltage Vddl, the first input control signal Sic1, the output control signal Soc, and the output signal Sout.

In addition, the reference voltage Vddh is settled before the second signal segment Sic12 of the first input control signal Sic1 is received by the control circuit 102. When the audio signal output system is powered-on, the driver circuit 104 is designed to operate under a specific power state (i.e., the initial state of the driver circuit 104), and when the second signal segment Sic12 of the first input control signal Sic1 is received by the control circuit 102, the driver circuit 104 keeps operating under the specific power state (i.e., the default state of the driver circuit 104). Please note that the present invention does not limit the specific power state to a power-on state or a power-off state. In this embodiment, the specific power state is set as the power-on state, and in another embodiment, the specific power state is set as the power-off state.

Furthermore, in this embodiment, the control circuit 102 is implemented by a signal path, such as a conducting path, for delivering the first input control signal Sic1 to the driver circuit 104. Therefore, the first input control signal Sic1 is similar to the output control signal Soc. Please refer to FIG. 2 again. When the audio signal output system is powered-on at time t1, the voltage of the reference voltage Vddh starts to rise and settle at time t2. Meanwhile, the first signal segment Sic11 of the first input control signal Sic1 is inputted to the driver circuit 104 at time t1. Please note that the first signal segment Sic11 of the first input control signal Sic1 is unknown since the reference voltage Vddl of the input circuit 106 is not settled yet. Therefore, in this embodiment, the first signal segment Sic11 of the first input control signal Sic1 is inappropriately utilized to control the operation of the driver circuit 104. ln other words, the driver circuit 104 is set to enter the initial state when the audio signal output system is powered-on at time t1. Since the initial state of the driver circuit 104 is set as the power-on state, the driver circuit 104 starts to charge an output terminal Nout of the driver circuit 104 after time t1. Then, the voltage of the output signal Sout rises gradually after time t1.

The voltage of the reference voltage Vddl starts to rise at time t3 and settle at time t4, meaning that the input circuit 106 is turned-on. When the input circuit 106 is turned-on, the input circuit 106 outputs the second signal segment Sic12 of the first input control signal Sic1 to the driver circuit 104. In this embodiment, the second signal segment Sic12 of the first input control signal Sic1 controls the driver circuit 104 to enter the default state, which is also the power-on state. Therefore, after time t4, the driver circuit 104 continues to charge the output terminal Nout, and the voltage of the output signal Sout rises gradually and continuously as shown in FIG. 2. Accordingly, the period of the first signal segment Sic11 corresponds to the first sub-period of the power up of the signal output device 100, the period of the second signal segment Sic12 corresponds to the second sub-period of the power up of the signal output device 100, and the first sub-period and the second sub-period may be separated by the settle time (i.e., t4) of the reference voltage Vddl approximately, in which the first sub-period is defined before the time t4 and the second sub-period is defined after the time t4. According to the embodiment, the driver circuit 104 charges the output terminal Nout until the voltage of the output control Sout reaches a common mode voltage Vcm at time t5. For example, the common mode voltage Vcm may be (1/2)*Vddh. Accordingly, since there is no sharp transition of voltage when the input circuit 106 is turned on at time t4, the pop-noise phenomenon mentioned in the related art is decreased.

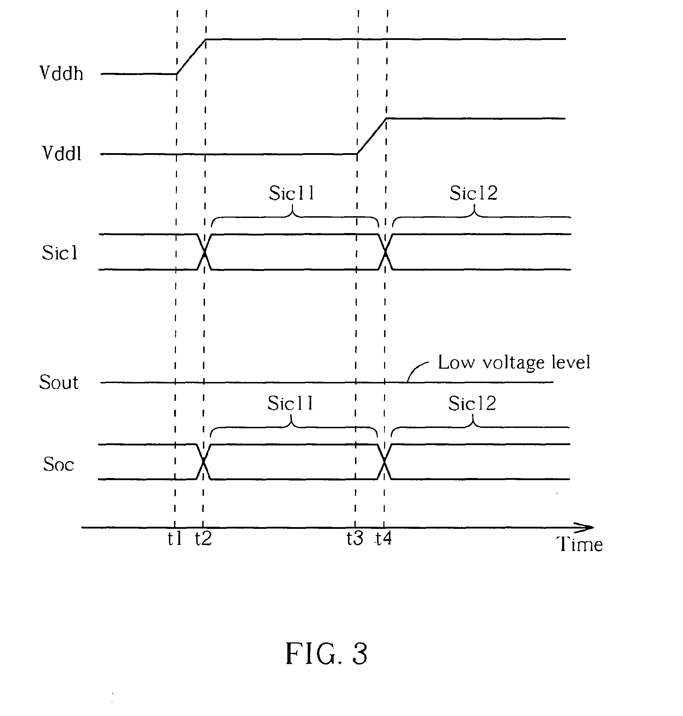

Please note that, in another embodiment of the present invention, the specific power state of the signal output device 100 is set as the power-off state. Then, the power-on sequence is shown in FIG. 3. FIG. 3 is a timing diagram illustrating the power-on sequence of the reference voltage Vddh, the reference voltage Vddl, the first input control signal Sic1, the output control signal Soc, and the output signal Sout according to a second embodiment of the signal output device 100 shown in FIG. 1. Similar to the above-mentioned embodiment, the control circuit 102 is implemented by the signal path, such as the conducting path, for delivering the first input control signal Sic1 to the driver circuit 104. Therefore, the first input control signal Sic1 is similar to the output control signal Soc. Please refer to FIG. 3 again. When the audio signal output system is powered-on at time t1, the voltage of the reference voltage Vddh starts to rise and settle at time t2. Meanwhile, the first signal segment Sic11 of the first input control signal Sic1 is inputted to the driver circuit 104 at time t1. Please note that the first signal segment Sic11 of the first input control signal Sic1 is unknown since the reference voltage Vddl of the input circuit 106 is not settled yet. Therefore, in this embodiment, the first signal segment Sic11 of the first input control signal Sic1 is inappropriately utilized to control the operation of the driver circuit 104. In other words, the driver circuit 104 is set to enter the initial state when the audio signal output system is powered-on at time t1. Since the initial state of the driver circuit 104 is set as the power-off state, the driver circuit 104 keeps the voltage of the output signal Sout at the low voltage level after time t1. In other words, the driver circuit 104 does not charge the output terminal Nout of the driver circuit 104 after time t1.

The voltage of the reference voltage Vddl starts to rise at time t3 and settle at time t4, meaning that the input circuit 106 is turned-on. When the input circuit 106 is turned-on, the input circuit 106 outputs the second signal segment Sic12 of the first input control signal Sic1 to the driver circuit 104. ln this embodiment, the second signal segment Sic12 of the first input control signal Sic1 controls the driver circuit 104 to enter the default state, which is also the power-off state. Therefore, after time t4, the driver circuit 104 keeps the voltage of the output signal Sout intact, which is the low voltage level as shown in FIG. 3. Accordingly, since there is no sharp transition of voltage when the input circuit 106 is turned on at time t4, the pop-noise phenomenon mentioned in the related art is decreased.

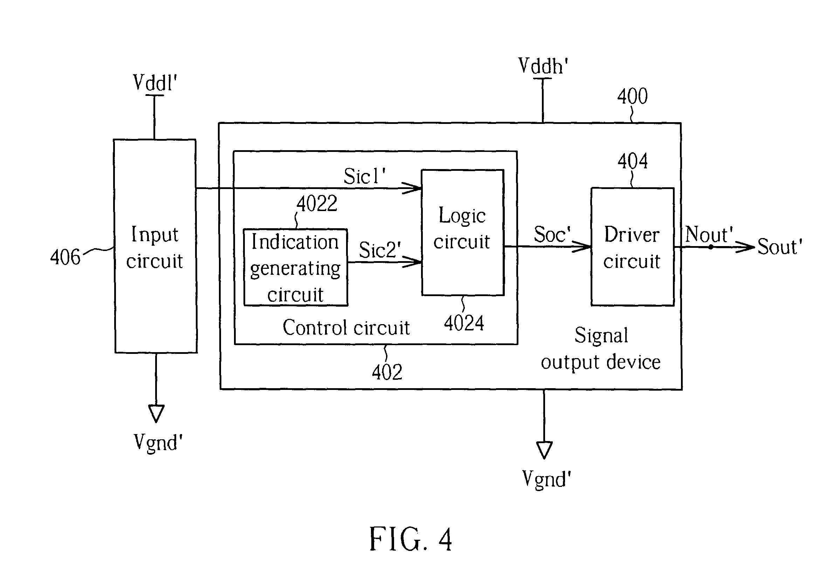

Please refer to FIG. 4. FIG. 4 is a diagram illustrating a signal output device 400 according to a third embodiment of the present invention. The signal output device 400 is applicable in an audio signal output system. The signal output device 400 comprises a control circuit 402 and a driver circuit 404. The control circuit 402 receives at least a first input control signal Sic1' and outputs an output control signal Soc' according to at least the first input control signal Sic1', wherein the first input control signal Sic1' comprises a first signal segment Sic11' followed by a second signal segment Sic12'. The driver circuit 404 is coupled to the control circuit 402 and operated according to a first supply power for receiving the output control signal Soc' from the control circuit 402 and selectively generating an output signal Sout' according to the output control signal Soc' when the first supply power is turned on, wherein the first supply power is defined between a relatively high reference voltage Vddh' and a ground voltage Vgnd'. Furthermore, the driver circuit 404 is coupled to a speaker (not shown), and the speaker is utilized for amplifying the output signal Sout'. In other words, the driver circuit 404 is an audio signal output circuit in this embodiment, and the output signal Sout' is an audio signal.

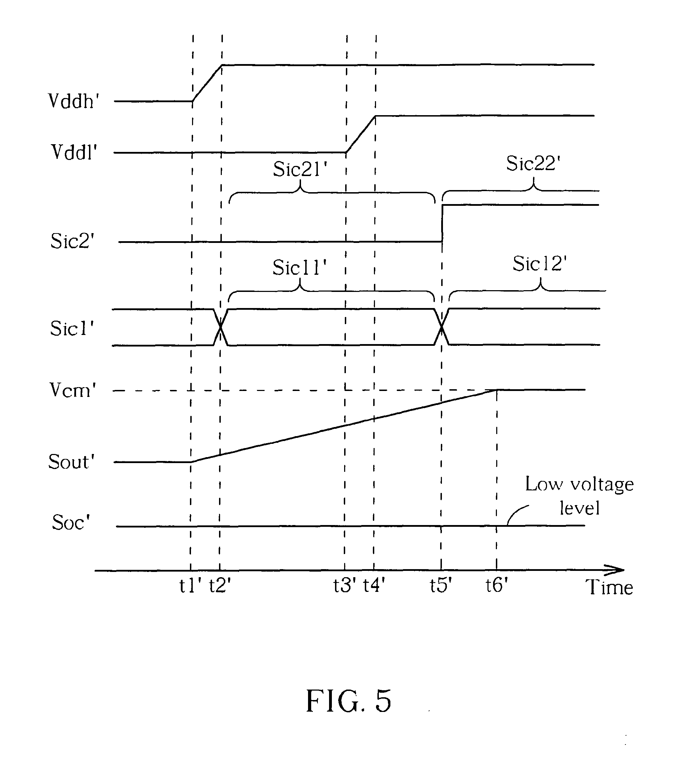

Furthermore, the control circuit 402 comprises an indication signal generating circuit 4022 and a logic circuit 4024. In this embodiment, the indication signal generating circuit 4022 is implemented by a power-on reset circuit, but this is not a limitation of the present invention. In another embodiment of the present invention, the indication signal generating circuit 4022 may be implemented by a power-off reset circuit. The indication signal generating circuit 4022 generates a second input control signal Sic2' when the supply power is turned on, wherein the second input control signal Sic2' comprises a third signal segment Sic21' followed by a fourth signal segment Sic22'. The logic circuit 4024 receives the first input control signal Sic1' and the second input control signal Sic2', and generates the output control signal Soc' according to the first input control signal Sic1' and the second input control signal Sic2'. Please note that, to clearly illustrate the operation of the signal output device 400, an input circuit 406 is further included in FIG. 4. ln this embodiment, the input circuit 406 is implemented by a register, but this is not a limitation of the present invention. The register may be controlled by firmware or a hardware controller, and the register may load/store a specific data from the hardware controller and output the specific data as the first input control signal Sic1' to the signal output device 400 when power up. Moreover, the register may store a default data and output the default data as the first input control signal Sic1' to the signal output device 400 when power up. The input circuit 406 operated under a second supply power is utilized for generating the first input control signal Sic1', wherein the second supply power is defined between a relatively low reference voltage Vddl' and the ground voltage Vgnd', and the reference voltage Vddh' is higher than the reference voltage Vddl'. More specifically, in one embodiment of the present invention, the signal output device 400 is an analog circuit, and the input circuit 406 is a digital circuit, thus the reference voltage Vddh' is in analog domain and the reference voltage Vddl' is in digital domain. Furthermore, when the audio signal output system is powered-on, the reference voltage Vddh' is turned on (or settled) faster than the reference voltage Vddl' as shown in FIG. 5. FIG. 5 is a timing diagram illustrating a power-on sequence of the reference voltage Vddh', the reference voltage Vddl', the first input control signal Sic1', the second input control signal Sic2', the output control signal Soc', and the output signal Sout'.

According to the embodiment, a starting point, i.e. time t5', of the second signal segment Sic12' of the first input control signal Sic1' is substantially identical to a starting point of the fourth signal segment Sic22' of the second input control signal Sic2', the logic circuit 4024 utilizes the first signal segment Sic11' of the first input control signal Sic1' and the third signal segment Sic21' of the second input control signal Sic2' to generate the output control signal Soc' with a specific logic level, and the logic circuit 4024 utilizes the second signal segment Sic12' of the first input control signal Sic1' and the fourth signal segment Sic22' of the second input control signal Sic2' to generate the output control signal Soc' with the specific logic level. Furthermore, the reference voltage Vddh' is turned on before the second signal segment Sic12' of the first input control signal Sic1' is received by the logic circuit 4024. When the audio signal output system is powered-on, the driver circuit 404 is designed to operate under a specific power state (i.e., the initial state of the driver circuit 404), and when the second signal segment Sic12' of the first input control signal Sic1' and the fourth signal segment Sic22' of the second input control signal Sic2' are received by the logic circuit 4024, the driver circuit 404 keeps operating under the specific power state (i.e., the default state of the driver circuit 404). Please note that the present invention does not limit the specific power state to a power-on state or a power-off state. In this embodiment, the specific power state is set as the power-on state, and in another embodiment, the specific power state is set as the power-off state.

When the audio signal output system is powered-on at time t1', the voltage of the reference voltage Vddh' starts to rise, and then settles at time t2'. At the same time, the first signal segment Sic11' of the first input control signal Sic1' and the third signal segment Sic21' of the second input control signal Sic2' are inputted to the logic circuit 4024 at time t1'. Please note that the first signal segment Sic11' of the first input control signal Sic1' is unknown since the reference voltage Vddl' of the input circuit 406 is not settled yet, and the third signal segment Sic21' of the second input control signal Sic2' is a predetermined value, which may be a low voltage level, since the reference voltage Vddh' is settled. Therefore, in this embodiment, the logic circuit 4024, which can be implemented by an AND gate, utilizes the third signal segment Sic21' to gate the first signal segment Sic11'. Then, the output control signal Soc', which may be a low voltage level, is outputted by the logic circuit 4024. The low voltage level of the output control signal Soc' controls the driver circuit 404 to operate under the initial state, i.e., the power-on state. Please note that, the logic circuit 4024
is not limited in the above-mentioned AND gate, any other circuits capable of gating the first signal segment Sic11' according to the third signal segment Sic21' are belongs to the scope of the logic circuit 4024. For example, the logic circuit 4024 may be implemented by a multiplexer (MUX). Accordingly, the first signal segment Sic11' of the first input control signal Sic1' does not affect the operation of the driver circuit 404. In other words, the driver circuit 404 enters the initial state when the audio signal output system is powered-on at time t1'. Since the initial state of the driver circuit 404 is set as the power-on state, the driver circuit 404 starts to charge an output terminal Nout' of the driver circuit 404 after time t1'. The voltage of the output signal Sout rises gradually after time t1'.

The reference voltage Vddl' starts to rise at time t3', and then settles at time t4', meaning that the input circuit 406 is turned-on. When the input circuit 406 is turned-on, the input circuit 406 outputs the second signal segment Sic12' of the first input control signal Sic1' to the logic circuit 4024, while the indication signal generating circuit 4022 generates the fourth signal segment Sic22' of the second input control signal Sic2' to the logic circuit 4024. Then, the logic circuit 4024 utilizes the second signal segment Sic12' and the fourth signal segment Sic22' to generate the output control signal Soc', and the output control signal Soc' is kept at the low voltage level since the second signal segment Sic12' is a low voltage level, which is a predetermined value. The low voltage level of the output control signal Soc' controls the driver circuit 404 to operate under the default state, i.e., the power-on state. Since the default state of the driver circuit 404 is the power-on state, the driver circuit 404 continues to charge the output terminal Nout' of the driver circuit 404 after time t5', and the voltage of the output signal Sout' rises gradually as shown in FIG. 5. Accordingly, the period of the first signal segment Sic11' corresponds to the first sub-period of the power up of the signal output device 400, the period of the second signal segment Sic12' corresponds to the second sub-period of the power up of the signal output device 400, and the first sub-period and the second sub-period may be separated by the generation of the fourth signal segment Sic22' (i.e., t5') approximately, in which the first sub-period is defined before the time t5' and the second sub-period is deined after the time t5'. According to the embodiment, the driver circuit 404 charges the output terminal Nout' until the voltage of the output signal Sout' reaches a common mode voltage Vcm' at time t6'. For example, the common mode voltage Vcm' may be (1/2)*Vddh'. Accordingly, since there is no sharp transition of voltage when the second signal segment Sic12' is generated by the input circuit 406 at time t5', the pop-noise phenomenon of the related art is reduced. Please note that, the second input control signal Sic2' may be a RSTB (Reset) signal of the logic circuit 4024 or other signal which is capable of detecting the settlement of the reference voltage Vddl'. ln other words, the second input control signal Sic2' can be any signal that is capable of indicating whether the reference voltage Vddl' is ready/settled or not, and the indication may be a voltage change from low level to high level or from high level to low level.

Please note that, by appropriately modifying the signal output device 400, those skilled in this art will understand that the initial state and the default state of the driver circuit 404 can also be set as the power-off state, which is similar to the embodiment shown in FIG. 3. For example, the logic circuit 4024 may be implemented by a NAND gate in another embodiment of the present invention. By doing this, the driver circuit 404 may remain in the power-off state rather than the power-on state, and thus the voltage level of the output signal Sout' stays at the low voltage level when the input circuit 406 is turned-on. Accordingly, since there is no sharp transition of voltage when the second signal segment Sic12' is generated by the input circuit 406 at time t5', the pop-noise phenomenon of the related art is reduced.

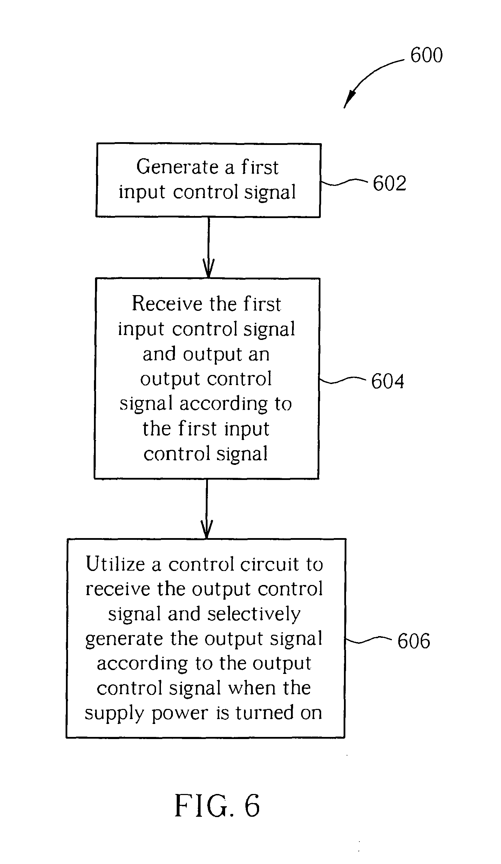

Please refer to FIG. 6. FIG. 6 is a flowchart illustrating a signal output method 600 according to a fourth embodiment of the present invention. The signal output method 600 is applicable in an audio signal output system. Please note that, to more clearly illustrate the signal output method 600, the signal output method 600 is described in conjunction with the signal output device 100 herein. Provided that substantially the same result is achieved, the steps of the flowchart shown in FIG. 6 need not be in the exact order shown and need not be contiguous; that is, other steps can be intermediate. The signal output method 600 comprises the following steps:
- Step 602:: Generate the first input control signal Sic1;
- Step 604:: Receive the first input control signal Sic1 and output the output control signal Soc according to the first input control signal Sic1, wherein the first input control signal Sic1 comprises the first signal segment Sic11 followed by a second signal segment Sic12;
- Step 606:: Utilize the control circuit 104, operated according to a supply power, to receive the output control signal Soc and selectively generate the output signal Sout according to the output control signal Soc when the supply power is turned on.

Please refer to FIG. 6 in conjunction with FIG. 2. In this exemplary embodiment, when the supply power of the signal output device 100 is turned on, the control circuit 104 enters the initial state. Since the initial state of the control circuit 104 is set as power-on state, the control circuit 104 starts to charge the output terminal Nout. Then, the voltage of the output signal Sout rises gradually as shown in FIG. 2. Meanwhile, the first input control signal Sic1 is generated in step 602. In this embodiment, the first input control signal Sic1 is the output control signal Soc (step 604). Since the first signal segment Sic11 of the first input control signal segment Sic1 is unknown before time t3, the first signal segment Sic11 is inappropriately utilized to control the control circuit 104. Then, at time t4, when the input circuit 106 is turned on, the second signal segment Sic12 is generated by the input circuit 106, and the second signal segment Sic12 is transmitted to the control circuit 104. Since the second signal segment Sic12 is the predetermined value, such as a low voltage level, the control circuit 104 receives the second signal segment Sic12 to enter the default state, which is also the power-on state. Then, the control circuit 104 continues to charge the output terminal Nout (step 606). Therefore, by setting the initial state of the control circuit 104 to be the same as the default state, the sharp transition of voltage when the input circuit 106 is turned on at time t4 can be avoided, and thus the pop-noise phenomenon of the related art is reduced.

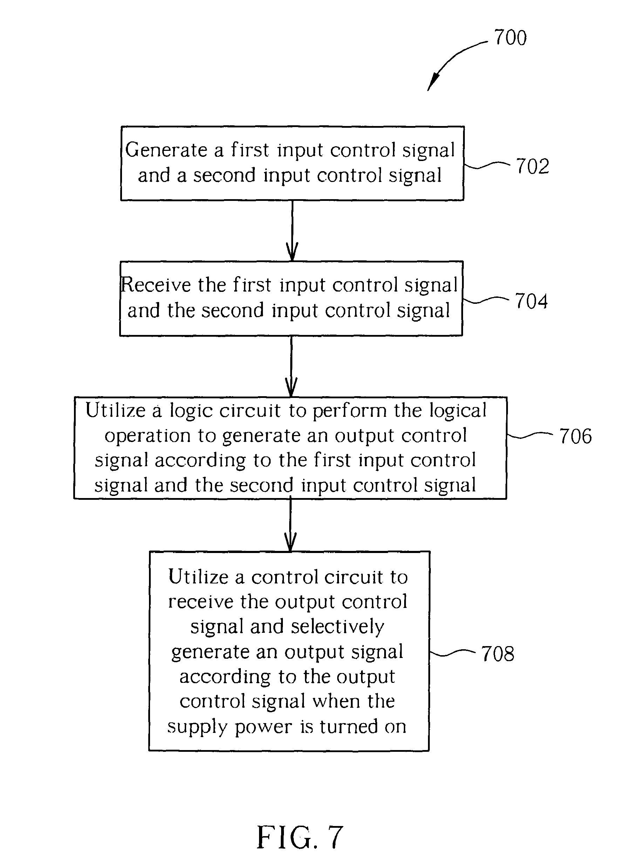

Please refer to FIG. 7. FIG. 7 is a flowchart illustrating a signal output method 700 according to a fifth embodiment of the present invention. The signal output method 700 is applicable in an audio signal output system. Please note that, to more clearly illustrate the signal output method 700, the signal output method 700 is described in conjunction with the signal output device 400 herein. Provided that substantially the same result is achieved, the steps of the flowchart shown in FIG. 7 need not be in the exact order shown and need not be contiguous; that is, other steps can be intermediate. The signal output method 700 comprises the following steps:
- Step 702:: Generate the first input control signal Sic1' and the second input control signal Sic2';
- Step 704:: Receive the first input control signal Sic1' and the second input control signal Sic2';
- Step 706:: Utilize the logic circuit 4024 to perform the logical operation to generate the output control signal Soc' according to the first input control signal Sic1' and the second input control signal Sic2';
- Step 708:: Utilize the control circuit 404, operated according to the supply power, to receive the output control signal Soc' and selectively generate the output signal Sout' according to the output control signal Soc' when the supply power is turned on.

Please refer to FIG. 7 in conjunction with FIG. 5. In this exemplary embodiment, the first input control signal Sic1' comprises the first signal segment Sic11' followed by the second signal segment Sic12', and the second input control signal Sic2' comprises the third signal segment Sic21' followed by the fourth signal segment Sic22'. Furthermore, the starting point, i.e. time t5', of the second signal segment Sic12' of the first input control signal Sic1' is substantially identical to a starting point of the fourth signal segment Sic22' of the second input control signal Sic2' (step 702).

When the audio signal output system is powered-on at time t1', the voltage of the reference voltage Vddh' starts to rise, and then settles at time t2'. At the same time, the first signal segment Sic11' of the first input control signal Sic1' and the third signal segment Sic21' of the second input control signal Sic2' are inputted to the logic circuit 4024 at time t1' (step 704). Please note that the first signal segment Sic11' of the first input control signal Sic1' is unknown since the reference voltage Vddl' of the input circuit 406 is not settled yet, and the third signal segment Sic21' of the second input control signal Sic2' is a predetermined value, which may be a low voltage level, since the reference voltage Vddh' is settled. Therefore, in this embodiment, the logic circuit 4024, which may be implemented by an AND gate, utilizes the third signal segment Sic21' to gate the first signal segment Sic11'. Then, the output control signal Soc', which may be a low voltage level, is outputted by the logic circuit 4024 (step 706). Then, the low voltage level of the output control signal Soc' controls the driver circuit 404 to operate under the initial state, i.e., the power-on state. Accordingly, the first signal segment Sic11' of the first input control signal Sic1' does not affect the operation of the driver circuit 404. ln other words, the driver circuit 404 enters the initial state when the audio signal output system is powered-on at time t1'. Since the initial state of the driver circuit 404 is set as the power-on state, the driver circuit 404 starts to charge an output terminal Nout' of the driver circuit 404 after time t1'. Then, the voltage of the output signal Sout rises gradually after time t1' (step 708).

The voltage of the reference voltage Vddl' starts to rise at time t3' and settles at time t4', meaning that the input circuit 406 is turned-on. When the input circuit 406 is turned-on, the input circuit 406 outputs the second signal segment Sic12' of the first input control signal Sic1' to the logic circuit 4024, while the indication signal generating circuit 4022 generates the fourth signal segment Sic22' of the second input control signal Sic2' to the logic circuit 4024 (step 704). Then, the logic circuit 4024 utilizes the second signal segment Sic12' and the fourth signal segment Sic22' to generate the output control signal Soc', and the output control signal Soc' is kept at the low voltage level since the second signal segment Sic12' is a low voltage level, which is a predetermined value (step 706). Then, the low voltage level of the output control signal Soc' controls the driver circuit 404 to operate under the default state, i.e., the power-on state. Since the default state of the driver circuit 404 is the power-on state, the driver circuit 404 continues to charge the output terminal Nout' of the driver circuit 404 after time t5', and the voltage of the output signal Sout' rises gradually as shown in FIG. 5 (step 708). According to the embodiment, the driver circuit 404 charges the output terminal Nout' until the voltage of the output signal Sout' reaches a common mode voltage Vcm' at time t6'. For example, the common mode voltage Vcm' may be (1/2)*Vddh'. Accordingly, since there is no sharp transition of voltage when the second signal segment Sic12' is generated by the input circuit 406 at time t5', the pop-noise phenomenon of the related art is reduced.

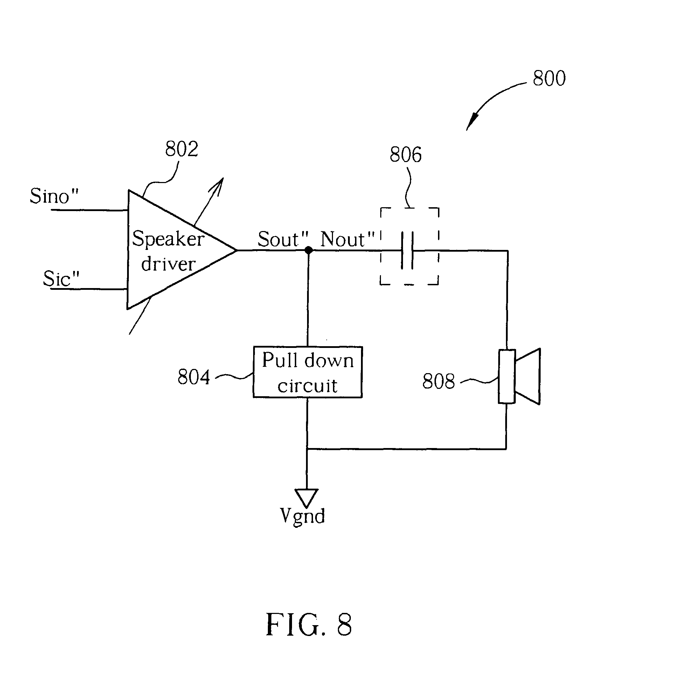

Please refer to FIG. 8. FIG. 8 is a diagram illustrating an audio signal amplifying system 800 according to a sixth embodiment of the present invention. The audio signal amplifying system 800 comprises a speaker driver 802, a pull down circuit 804, a capacitive device 806, and a speaker 808. The speaker driver 802 generates an output audio signal Sout" to drive the speaker 808 according to an input audio signal Sino". The speaker driver 802 further receives an input control signal Sic" for controlling the power up of the speaker driver 802 as mentioned in the above embodiments. In this embodiment, the speaker driver 802 possesses the similar technical characteristic to the above-mentioned embodiment, i.e., the signal output device 100, the signal output device 400, the signal output method 600, or the signal output method 700, therefore the detailed description about the speaker driver 802 is omitted here for brevity. In addition, the pull down circuit 804 is utilized for pulling down the voltage level at the output terminal Nout" of the speaker driver 802 during the power up of the speaker driver 802. The pull down circuit 804 may be implemented by a bipolar transistor (BJT) or other type of transistor. The capacitive device 806 is utilized for filtering the DC voltage of the output audio signal Sout". The speaker 808 amplifies the filtered output audio signal Sout".

According to the description related to the above-mentioned embodiments, the pop-noise phenomenon generated by the register transition during the power up is reduced. Therefore, the pull down circuit 804 may only deal with the pop-noise generated by the other circuits, such as the pop-noise sourced from the power down circuit of the speaker driver. Therefore, compared to the conventional audio signal output system, the design of the pull down circuit 804 can be relaxed since most of the pop-noise is eliminated by the above-disclosed method. For example, the pop-noise can be muted by the BJT that is not as strong as (i.e., the weaker BJT or the smaller BJT) the conventional one. In other words, the cost of the audio signal amplifying system 800 is reduced.

Compared to the related art, there is no voltage changing occurred upon the output control signal Soc or Soc' when the signal output device 100 or 400 enter the second sub-period from the first sub-period of the power up period whereas the related art does, thus the pop-noise phenomenon is improved. More specifically, by setting the initial state of the control circuit of the audio signal output system to be the same as its default state, the sharp transition of voltage at the output terminal of the control circuit can be avoided, and thus the pop-noise phenomenon of the related art is reduced. Furthermore, by utilizing the disclosed method, the cost of the audio signal amplifying system 800 is reduced.

For completeness, various aspects of the invention are set out in the following numbered clauses:
Clause 1: A signal output device, comprising:
   a control circuit, for receiving at least a first input control signal and outputting an output control signal according to at least the first input control signal, wherein the first input control signal comprises a first signal segment followed by a second signal segment; and
   a driver circuit, coupled to the control circuit and operated according to a supply power, for receiving the output control signal from the control circuit and selectively generating an output signal according to the output control signal when the supply power is turned on;
   wherein the supply power is turned on before the second signal segment of the first input control signal is received by the control circuit; when the supply power is turned on, the driver circuit operates under a specific power state; and when the second signal segment of the first input control signal is received by the control circuit, the driver circuit keeps operating under the specific power state.
Clause 2: The signal output device of clause 1, wherein the specific power state is a power-on state.
Clause 3: The signal output device of clause 1, wherein the specific power state is a power-off state.
Clause 4: The signal output device of clause 1, wherein the control circuit reads the first input control signal from a register.
Clause 5: The signal output device of clause 1, wherein the driver circuit is an audio signal output circuit.
Clause 6: The signal output device of clause 1, wherein the control circuit comprises:
   a indication signal generating circuit, for generating a second input control signal when the supply power is turned on; and
   a logic circuit, for receiving the first input control signal and the second input control signal, and generating the output control signal according to the first input control signal and the second input control signal.
Clause 7: The signal output device of clause 6, wherein the second input control signal comprises a third signal segment followed by a fourth signal segment; a starting point of the second signal segment of the first input control signal is substantially identical to a starting point of the fourth signal segment of the second input control signal; the logic circuit utilizes the first signal segment of the first input control signal and the third signal segment of the second input control signal to generate the output control signal with a specific logic level; and the logic circuit utilizes the second signal segment of the first input control signal and the fourth signal segment of the second input control signal to generate the output control signal with the specific logic level.
Clause 8: A signal output method, comprising:
   receiving at least a first input control signal and outputting an output control signal according to at least the first input control signal, wherein the first input control signal comprises a first signal segment followed by a second signal segment; and
   utilizing a control circuit, operated according to a supply power, to receive the output control signal and selectively generate an output signal according to the output control signal when the supply power is turned on;
   wherein the supply power is turned on before the second signal segment of the first input control signal is received; when the supply power is turned on, the control circuit operates under a specific power state; and when the second signal segment of the first input control signal is received, the control circuit keeps operating under the specific power state.
Clause 9: The signal output method of clause 8, wherein the specific power state is a power-on state.
Clause 10: The signal output method of clause 8, wherein the specific power state is a power-off state.
Clause 11: The signal output method of clause 8, wherein the first input control signal is read from a register.
Clause 12: The signal output method of clause 8, wherein the control circuit is an audio signal output circuit.
Clause 13: The signal output method of clause 8, wherein the step of receiving at least the first input control signal and outputting the output control signal comprises:
   generating a second input control signal when the supply power is turned on; receiving the first input control signal and the second input control signal; and
   utilizing a logic circuit to perform a logical operation to generate the output control signal according to the first input control signal and the second input control signal.
Clause 14: The signal output method of clause 13, wherein the second input control signal comprises a third signal segment followed by a fourth signal segment; a starting point of the second signal segment of the first input control signal is substantially identical to a starting point of the fourth signal segment of the second input control signal; the logic circuit utilizes the first signal segment of the first input control signal and the third signal segment of the second input control signal to generate the output control signal with a specific logic level; and the logic circuit utilizes the second signal segment of the first input control signal and the fourth signal segment of the second input control signal to generate the output control signal with the specific logic level.

All combinations and sub-combinations of the above-described features also belong to the invention.

## Claims

1. A signal output device (100, 400), **characterized by:**
a control circuit (102, 402), for receiving at least a first input control signal and outputting an output control signal according to at least the first input control signal, wherein the first input control signal comprises a first signal segment followed by a second signal segment; and
a driver circuit (104, 404), coupled to the control circuit (102, 402) and operated according to a supply power, for receiving the output control signal from the control circuit (102, 402) and selectively generating an output signal according to the output control signal when the supply power is turned on;
wherein that the supply power is turned on before the second signal segment of the first input control signal is received by the control circuit (102, 402); when the supply power is turned on, the driver circuit (104, 404) operates under a specific power state; and when the second signal segment of the first input control signal is received by the control circuit (102, 402), the driver circuit (104, 404) keeps operating under the specific power state.

2. The signal output device (100, 400) of claim 1, **characterized in that** the specific power state is a power-on state.

3. The signal output device (100, 400) of claim 1, **characterized in that** the specific power state is a power-off state.

4. The signal output device (100, 400) of claim 1, **characterized in that** the control circuit (102, 402) reads the first input control signal from a register (106, 406).

5. The signal output device (100, 400) of claim 1, **characterized in that** the driver circuit (104, 404) is an audio signal output circuit (104, 404).

6. The signal output device (400) of claim 1, **characterized in that** the control circuit (402) comprises:
a indication signal generating circuit (4022), for generating a second input control signal when the supply power is turned on; and
a logic circuit (4024), for receiving the first input control signal and the second input control signal, and generating the output control signal according to the first input control signal and the second input control signal.

7. The signal output device (400) of claim 6, **characterized in that** the second input control signal comprises a third signal segment followed by a fourth signal segment; a starting point of the second signal segment of the first input control signal is substantially identical to a starting point of the fourth signal segment of the second input control signal; the logic circuit (4024) utilizes the first signal segment of the first input control signal and the third signal segment of the second input control signal to generate the output control signal with a specific logic level; and the logic circuit (4024) utilizes the second signal segment of the first input control signal and the fourth signal segment of the second input control signal to generate the output control signal with the specific logic level.

8. A signal output method, **characterized by**:
receiving at least a first input control signal and outputting an output control signal according to at least the first input control signal, wherein the first input control signal comprises a first signal segment followed by a second signal segment; and
utilizing a control circuit (102, 402), operated according to a supply power, to receive the output control signal and selectively generate an output signal according to the output control signal when the supply power is turned on;
wherein that the supply power is turned on before the second signal segment of the first input control signal is received; when the supply power is turned on, the control circuit (102, 402) operates under a specific power state; and when the second signal segment of the first input control signal is received, the control circuit (102, 402) keeps operating under the specific power state.
